# EUROPÄISCHE PATENTSCHRIFT

(11) **EP 4 064 805 B1**
(45) Veröffentlichungstag und Bekanntmachung des Hinweises auf die Patenterteilung: **03.12.2025**
(21) Anmeldenummer: 21164098.2
(22) Anmeldetag: 22.03.2021
(51) Int. Cl.: H05K 7/14, H05K 1/02

(54) **ANORDNUNG ZUM BEFESTIGEN EINER LEITERPLATTE**
ASSEMBLY FOR ATTACHING A CIRCUIT BOARD
AGENCEMENT DESTINÉ À LA FIXATION À UNE CARTE DE CIRCUIT IMPRIMÉ

(43) Veröffentlichungstag der Anmeldung: 28.09.2022
(73) Patentinhaber: Siemens Aktiengesellschaft, 80333 München (DE)
(72) Erfinder: Schlagitweit, Andreas, 1020 Wien (AT); Weißinger, Martin, 3464 Hausleiten (AT); Fischer, Gerhard, 2191 Atzelsdorf (AT); Herold, Thomas, 1200 Wien (AT); Mitterlehner, Daniel, 1060 Wien (AT); Weinmeier, Harald, 1210 Wien (AT)
(74) Vertreter: Siemens Patent Attorneys

(56) Entgegenhaltungen:
- EP-B1- 0 033 850
- US-A- 6 088 228
- US-A1- 2004 218 371

## Beschreibung

### Technisches Gebiet

Die vorliegende Erfindung betrifft allgemein das Gebiet elektrischer und elektronischer Geräte, insbesondere den Bereich der Stromversorgungsgeräte sowie der leistungselektronischen Schaltungen. Im Speziellen bezieht sich die vorliegende Erfindung auf eine Anordnung, durch welche eine mit Bauelementen bestückte Leiterplatte eines elektrischen Geräts, z.B. einer leistungselektronischen Schaltung, mit einem weiteren Geräteteil, insbesondere einem Gehäuse, mechanisch verbunden bzw. an einem weiteren Geräteteil befestigt werden kann.

### Stand der Technik

Geräte, insbesondere elektrische oder elektronische Geräte, wie z.B. Stromversorgungsgeräte, Schaltnetzteile, leistungselektronische Schaltungen, Steuergeräte, etc., werden heutzutage üblicherweise aus elektrischen Bauelementen und/oder Baugruppen aufgebaut. Die Bauelemente sind dabei auf einer Trägerplatte - einer so genannte Leiterplatte - anbracht, welche einer mechanische Befestigung sowie über so genannte Leiterbahnen einer elektrischen Verbindung der Bauelemente dient. Die Bauelemente können z.B. mittels Anlöten auf Lötflächen oder in Lötaugen, mittels Aufkleben, etc. befestigt werden.

Mit der Entwicklung von so genannten oberflächenbestückbaren bzw. Surface Mounted Device (SMD)-Varianten elektrischer Bauelemente können z.B. auch Leistungsbauelemente flächig und automatisiert auf einer Trägerplatte bzw. Leiterplatte aufgelötet werden. Die Bestückung einer Leiterplatte für ein elektrisches Gerät erfolgt dabei üblicherweise in einer Fertigungslinie für SMD-Bestückung, wobei die Bestückung einer Leiterplatte aus mehreren Fertigungsschritten besteht. Diese Fertigungsschritte umfassen zumindest das Aufbringen von Lotpaste z.B. mittels eines Pastendruckers auf die zu bestückende Leiterplatte, das Bestücken der Leiterplatte mit elektrischen Bauelementen in einem SMD-Bestückungsautomaten und das Auflöten der Bauelemente in einem SMD-Ofen.

Bei der weiteren Montage bzw. Herstellung von elektrischen Geräten, wie z.B. Stromversorgungsgeräte, Schaltnetzteile, leistungselektronische Schaltungen, Steuergeräte, etc., werden mit elektrischen Bauelementen bestückte Leiterplatten mit beliebigen angrenzenden Geräteteilen (z.B. Gehäuse; eine weitere, bestückte Leiterplatte, etc.) mechanisch verbunden oder an diesen Geräteteilen, wie z.B. dem Gehäuse, befestigt. Dazu können beispielsweise auf der bestückten Leiterplatte Verbindungselemente angebracht werden, welche eine mechanische Verbindung mit dem weiteren, benachbarten Geräteteil (z.B. Gehäuse) z.B. unter Verwendung eines Befestigungsmittels (z.B. Zapfen, Stift, Niete, Schraube, etc.) ermöglichen. Die Anbringung des für die mechanische Verbindung notwendige Verbindungselements auf der Leiterplatte kann beispielweise mittels SMD-Bestückung oder mittels Handbestückung erfolgen, um damit dann eine Verbindung zu einem weiteren Geräteteil herzustellen.

Die Herausforderung bei der SMD-Bestückung von Verbindungselemente, welche aus nicht elektrisch leitfähigem Material (z.B. Kunststoff, Keramik, etc.) sind, besteht insbesondere darin, dass diese nicht mit der Leiterplatte verlötet werden können. Aktuell besteht z.B. die Möglichkeit nicht elektrisch leitfähige Verbindungselemente durch Verklebung mittels Klebepunkten auf der Leiterplatte anzubringen. Dazu können beispielsweise in einer SMD-Anlage zuerst die Klebepunkte auf der Leiterplatte gesetzt und dann mittels SMD-Bestückung das nicht elektrisch leitfähige Verbindungselement aufgebracht werden. Dabei sind allerdings neben der Bestückung und dem Auflöten der SMD-Bauelemente weitere Arbeitsschritte in der Fertigungsanlage notwendig.

Alternativ können Verbindungselemente aus nicht leitfähigem Material auch manuell bzw. mittels Handbestückung auf der Leiterplatte angebracht werden. Dies ist allerdings - vor allem bei einer Fertigung von hohen Stückzahlen - mit einem großen, zeitlichen Aufwand und relativ hohen Kosten verbunden.

Eine weitere Möglichkeit, Verbindungselemente mittels SMD-Bestückung automatisiert auf der Leiterplatte anzubringen, besteht beispielsweise darin elektrisch leitfähige Verbindungselemente zu verwenden, um die bestückte Leiterplatte mit beliebigen, angrenzenden und gegebenenfalls elektrisch leitenden Geräteteilen (z.B. Gehäuse) zu verbinden bzw. an diesen zu befestigen. Die elektrisch leitfähigen Verbindungselement können z.B. mittels der SMD-Bestückung mit elektrischen Bauelementen auf der Leiterplatte platziert und anschließend z.B. im SMD-Ofen aufgelötet werden. Der Einsatz von elektrisch leitfähigen Verbindungselementen weist allerdings den Nachteil auf, dass zwischen dem elektrisch leitfähigem Verbindungselement und den auf der Leiterplatte angebrachten elektrischen Bauelementen und elektrisch leitfähigen Bauteilen ein entsprechend großer Spannungsabstand gewährleistet werden muss.

Vor allem bei elektrischen Geräten, wie z.B. Schaltnetzteilen oder bei leistungselektronischen Schaltungen sind üblicherweise vorgegebene Spannungsabstände bzw. Mindestabstände für so genannte Luft- und Kriechstrecken zwischen leitenden Teilen des Geräts zu berücksichtigen. D.h. es sind z.B. aus Sicherheits- und/oder funktionstechnischen Gründen Mindestabstände zwischen z.B. Leiterbahnen, Bauelementkontaktierungen, elektrisch leitfähigen Bauelemente, etc. auf einer Leiterplatte und weiteren elektrisch leitfähigen Geräteteilen wie z.B. Kühlkörpern, Gehäuseteilen, Befestigungsmitteln, etc., um beispielsweise Personen oder Geräte vor Auswirkungen von elektrischer Spannung und/oder Strom bestmöglich zu schützen. Derartige Mindestabstände sind beispielsweise in Normen, wie z.B. in der Europäische Norm EN 60 664-1, etc. vorgegeben.

Da neu entwickelte elektrische Geräte, wie z.B. Schaltnetzteile, Stromversorgungsgeräte, leistungselektronische Schaltungen, etc. und in der Folge darin verbaute, bestückte Leiterplatten stetig kleiner und platzsparender werden, wird es mittlerweile immer schwieriger auf den Leiterplatten vorgegebene Spannungsabstände sowie Luft- und Kriechstrecken einzuhalten. Zusätzlich werden die elektrischen Geräte auch immer komplexer, wodurch eine Packungsdichte der elektrischen Bauelemente auf der jeweiligen Leiterplatte steigt. Dadurch wird es immer schwieriger ein elektrisch leitfähiges Verbindungselement auf einer mit Bauelementen bestückten Leiterplatte an einer geeigneten Stelle zu platzieren, um die zulässige Spannungsabstände sowie Luft- und Kriechstrecken zu anderen Bauelementen einzuhalten. Das Problem dabei ist, dass durch das Verbindungselement z.B. eine elektrisch leitfähige Verbindung zwischen elektrisch leitfähigen Bauelementen auf der Leiterplatte und dem weiteren Geräteteil (z.B. Gehäuse) hergestellt wird. Dadurch kann es beispielsweise zu einer Unterschreitung eines zulässigen Spannungsabstands sowie von Luft- und Kriechstrecken kommen.

Aus der EP 0 033 850 B1 ist ein Verfahren zum lösbaren Befestigen einer Leiterplatte in einem Gerät der Nachrichtentechnik bekannt, bei dem die Leiterplatte auf mit einem Kopf versehene Abstandselemente aufgelegt wird, wobei der Kopf durch die Leiterplatte hindurchragt. Nach seitlichem Verschieben wird die Leiterplatte durch einen Teil des Gehäuseaufbaus arretiert.

Die US 6 088 228 A beschreibt eine Schutzabdeckung für ein Mehrchipmodul, wobei die Befestigung der Schutzabdeckung an der gedruckten Schaltungsplatine einen Verriegelungsmechanismus mit minimalen Platzanforderungen auf der Platine verwendet.

Aus der US2004/218371 A1 ist ein Abstandshalter für Leiterplatten bekannt, der dazu dient, eine physische Verbindung zwischen zwei Leiterplatten bereitzustellen, während dazwischen ein Mindestabstand für die Aufnahme aller erforderlichen elektronischen Komponenten aufrechterhalten wird.

### Darstellung der Erfindung

Der Erfindung liegt daher die Aufgabe zugrunde, eine Anordnung zur mechanischen Verbindung einer Leiterplatte mit einem weiteren Gerätteil anzugeben, welche auf einfache Weise automatisiert, insbesondere mittels SMD-Bestückung, und platzsparend realisierbar ist und mit welcher eine vorgegebener Spannungsabstand eingehalten werden kann.

Diese Aufgabe wird durch eine Anordnung eingangs angeführter Art mit den Merkmalen des unabhängigen Anspruchs gelöst. Vorteilhafte Ausführungsformen der vorliegenden Erfindung sind in den abhängigen Ansprüchen beschrieben.

Erfindungsgemäß erfolgt die Lösung der Aufgabe durch eine Anordnung, durch welche eine mit elektrischen Bauelementen bestückbare Leiterplatte mit einem weiteren Geräteteil, wie z.B. einem Gehäuse eines elektrischen Geräts (z.B. einer Stromversorgung oder einem Schaltnetzteil), verbunden werden kann bzw. an diesem weiteren Geräteteil befestigt werden kann. Die Anordnung weist dabei zumindest ein Verbindungselement aus nicht elektrisch leitfähigem Material (z.B. Kunststoff, Keramik, etc.) sowie zumindest ein elektrisches Bauelement auf. Das Verbindungselement ist dazu eingerichtet, ein Befestigungsmittel für eine Verbindung mit dem weiteren Geräteteil aufzunehmen, und weist zumindest einen Grundkörper und eine Gegenhalterung auf. Dabei ist der Grundkörper in einen entsprechenden Auslass in der Leiterplatte einfügbar. Weiterhin ist der Grundkörper dazu eingerichtet, ein Verdrehen des Verbindungselements nach Einfügen in die Leiterplatte zu verhindern. Die Gegenhalterung, welche an einem in Einfügerichtung oberen Ende des Verbindungselements bzw. des Grundkörpers angebracht ist, weist weiterhin zumindest einen Abschnitt auf, welche - beispielsweise als Auskragung - über einen Querschnitt des Grundkörpers hinausragt, um ein Durchfallen des Verbindungselements durch den Auslass in der Leiterplatte beim Einfügen z.B. mittels SMD-Bestückung zu verhindern. Weiterhin ragt der Grundkörper mit zumindest einem Abschnitt über einen Querschnitt der Gegenhalterung hinaus, wobei dieser zumindest eine Abschnitt des Grundkörpers und der zumindest eine Abschnitt der Gegenhalterung zueinander versetzt angeordnet sind. D.h., der zumindest eine Abschnitt des Grundkörper und der zumindest eine Abschnitt der Gegenhalterung sind derart zueinander angeordnet, dass es zu keiner Überdeckung dieser Abschnitte kommt. Weiterhin ist das zumindest eine elektrische Bauelement der Anordnung derart auf der Leiterplatte lösbar oder unlösbar angebracht, dass das Verbindungselement lagestabil im Auslass in der Leiterplatte gehalten bzw. arretiert wird.

Der Hauptaspekt der erfindungsgemäß vorgeschlagenen Anordnung besteht darin, dass ein Verbindungselement aus nicht elektrisch leitfähigem Material, wie z.B. Kunststoff, Keramik, etc. auf einfache Weise automatisiert, vor allem mittels SMD-Bestückung in einer Fertigungsanlage ohne zusätzliche Verklebung auf einer Leiterplatte angebracht und arretiert werden kann. Durch einfache Arretierung des Verbindungselements aus nicht elektrisch leitfähigem Material auf der Leiterplatte können weiterhin Spannungsabstände verringert bzw. vorgegebene Mindestspannungsabstände sowie Luft- und Kriechstrecken im elektrischen Gerät leichter und einfacher eingehalten werden. Zudem besteht die Möglichkeit, das zumindest eine elektrische Bauelement, von welchen das Verbindungselement auf der Leiterplatte lagestabil gehalten wird, z.B. in einen Stromkreis bzw. in die Funktion des elektrischen Geräts miteinzubinden. Auf diese Weise wird durch die Anordnung auch eine effiziente Nutzung einer Fläche der Leiterplatte durch bestückte Bauelemente gewährleistet.

Das zumindest eine elektrische Bauelement ist derart auf der Leiterplatte angebracht, dass der zumindest eine Abschnitt des Grundkörpers des Verbindungselements, welcher den Querschnitt der Gegenhalterung überragt, vom zumindest einen elektrischen Bauelement überdeckt wird. Dazu kann beispielsweise eine obere Begrenzungsfläche des zumindest einen Abschnitts des Grundkörpers bei eingefügtem Zustand des Verbindungselements bündig mit einer Oberkante des Auslasses in der Leiterplatte abschließen oder etwas unterhalb dieser Oberkante zum Liegen kommen. Über dieser Stelle kann dann sehr einfach z.B. das zumindest eine elektrische Bauelement z.B. mittels Auflöten angebracht werden. Durch ein Überdecken des zumindest einen Abschnitt des Grundkörpers durch das zumindest eine Bauelement wird auf sehr einfach Weise z.B. ein Herausfallen des Verbindungselements bis zur Endmontage der Leiterplatte im elektrischen Gerät verhindert.

Um eine mechanische Verbindung zwischen der Leiterplatte und dem weiteren Geräteteil herzustellen, muss das Verbindungselement eine geeignete Möglichkeit bieten, damit ein Verbindungspunkt zwischen Leiterplatte und weiterem Geräteteil hergestellt werden kann. Diese Verbindung kann beispielsweise formschlüssig, kraftschlüssig und/oder gegebenenfalls auch stoffschlüssig sein. Dazu ist es vorteilhaft, wenn das Verbindungselement eine Bohrung aufweist. Diese Bohrung kann z.B. ohne Gewinde ausgeführt sein. Die mechanische und fixierende Verbindung zwischen der Leiterplatte und dem weiteren Geräteteil mittels der Anordnung kann beispielsweise durch Einbringen eines Stifts, einer Niete, eines Zapfen, welche auf dem weiteren Geräteteil angebracht ist, etc. oder mit Hilfe einer gewindefurchenden Schraube als Schraubverbindung hergestellt werden. Alternativ kann die Bohrung auch ein Gewinde aufweisen, um die Leiterplatte mittels der Anordnung bzw. des Verbindungselements am weiteren Geräteteil unter Verwendung z.B. einer Schraube, insbesondere einer metrischen Schraube, zu fixieren.

Es ist dabei günstig, wenn die Bohrung als Durchgangsloch oder als Sackloch ausgestaltet ist. Ein Sackloch weist dabei den Vorteil auf, dass ein in das Sackloch eingebrachtes Befestigungsmittel (z.B. Stift, Zapfen, Schraube, etc.) nicht über das Verbindungselement aus nicht elektrisch leitfähigem Material ragt.

Idealerweise weist der Grundkörper des Verbindungselements einen polygonförmigen Querschnitt auf. Durch einen polygonförmigen, insbesondere dreieckigen, rechteckigen, etc. Querschnitt des Grundkörper wird eine gewisse Verdrehsicherheit des Verbindungselements erreicht. Eine besondere Ausführungsform des Verbindungselements bzw. des Grundkörpers sieht beispielsweise einen hexagonalen Querschnitt vor. Dabei kann z.B. ein in Einfügerichtung unteres Ende des Grundkörpers eine Form einer Sechskantmutter aufweisen.

Eine bevorzugte Ausführungsform des Verbindungselements sieht vor, dass der zumindest ein Abschnitt des Grundkörpers des Verbindungselements, welcher über den Querschnitt des Gegenhalterung des Verbindungselements hinausragt, als Nase ausgestaltet ist. Diese zumindest eine Nase ist z.B. derart am Grundkörper angebracht, dass eine obere Seite der Nase bei eingefügtem Zustand des Verbindungselement bündig mit einer Oberkante des Auslasses in der Leiterplatte abschließen oder etwas unterhalb dieser Oberkante zum Liegen kommen. Die Nase bietet weitere Verdrehsicherheit des Verbindungselement - z.B. bei Endmontage, wenn beispielsweise eine Schraube in die Bohrung im Verbindungselement eingebracht wird. Der Grundkörper kann eine beliebige Anzahl an Nasen aufweisen, wobei die Anzahl der Nasen je nach Stabilitätsbedarf und zur Gewährleitung der Verdrehsicherheit entsprechend reduziert oder erweitert werden kann.

Alternativ kann der zumindest eine Abschnitt des Grundkörpers des Verbindungselements, welcher über den Querschnitt der Gegenhalterung des Verbindungselements hinausragt, als Rasthaken ausgestaltet sein. Eine derartige Ausführungsvariante des Verbindungselements kann beispielsweise bei einer möglichen Handbestückung eingesetzt werden, bei welcher das Verbindungselement manuell in den Auslass in der Leiterplatte eingefügt wird. Die Anzahl der an der Grundform vorgesehenen Rasthaken kann ebenfalls beliebig gewählt werden - je nach Stabilitätsbedarf und in Anhängigkeit von einer gewünschten Verdrehsicherheit des Verbindungselements, welches an der Leiterplatte weder verklebt noch verlötet wird.

Es ist weiterhin günstig, wenn die Gegenhalterung des Verbindungselements derart ausgestaltet ist, dass das Verbindungselement automatisiert in den Auslass in der Leiterplatte einfügbar ist. Das bedeutet, dass die Gegenhalterung, welche an einem oberen Ende des Verbindungselements in Einfügerichtung vorgesehen ist, eine Form aufweist, durch welche das Verbindungselement einfach mittels SMD-Bestückung im Auslass in der Leiterplatte platziert werden kann. Insbesondere sollte das Verbindungselement sehr einfach von einer Saugpipette eines SMD-Bestückungsautomaten angesaugt werden können.

Weiterhin ist das Verbindungselement nicht nur aus nicht elektrisch leitfähigem Material hergestellt, wie z.B. Kunststoff, Keramik, etc., sondern dieses Material ist auch hitzebeständig. Dabei liegt ein Schmelzpunkt des Materials über einem Temperaturbereichs eines Ofen einer automatisierten Fertigungsstrecke (z.B. SMD-Ofen einer SMD-Fertigungsanlage). Dadurch wird auf einfache Weise ein Stoffschluss des Verbindungselements mit der Leiterplatte verhindert.

Es kann allerdings auch günstig sein, wenn das Verbindungselement aus Materialen mit unterschiedlicher Hitzebeständigkeit hergestellt ist. Dabei kann z.B. die Gegenhalterung des Verbindungselement aus einem ersten Material bestehen, welches eine Glasübergangstemperatur aufweist, welche in einem Temperaturbereich des Ofens der automatisierten Fertigungsstrecke bzw. Fertigungsanlage liegt. Der Grundkörper des Verbindungselements kann beispielsweise aus einem zweiten Material bestehen, welches einen Schmelzpunkt aufweist, welcher über einem Temperaturbereichs des Ofens der automatisierten Fertigungsanlage liegt. Dadurch kann beispielsweise die Gegenhaltung beim Durchlaufen der bestückten Leiterplatte durch den SMD-Ofen mit der Oberfläche der Leiterplatte verschmelzen und das Verbindungselement zusätzlichen Halt auf der Leiterplatte verleihen.

Idealerweise wird das Verbindungselement mittels Spritzguss bzw. bei Verwendung unterschiedlicher Materialen mittels Zweikomponentenspritzguss hergestellt. Mittels eines Spritzgussverfahrens kann das Verbindungselement sehr einfach in einer vorgegebenen Gestalt mit Grundform und Gegenhalterung gefertigt werden. Dazu wird z.B. der Werkstoff (z.B. Kunststoff) verflüssigt und unter Druck in ein entsprechende Form eingespritzt. Diese Herstellungsverfahren erlaubt idealerweise eine nahezu freie Wahl der Form und Oberflächenstruktur des Verbindungselements und ermöglicht sehr einfach und kosteneffizient eine Massenherstellung. Weiterhin ist es mittels eines Mehrkomponenten-Spritzgussverfahrens möglich, das Verbindungselement aus unterschiedlichen Materialen in einem Arbeitsgang herzustellen.

### Kurzbeschreibung der Zeichnung

Die Erfindung wird nachfolgend in beispielhafter Weise anhand der beigefügten Figuren erläutert. Dabei zeigen:
- Figur 1: eine perspektivische, schematische Darstellung einer beispielhaften Ausführungsform eines Verbindungselements der erfindungsgemäßen Anordnung
- Figur 2: schematisch und beispielhaft eine Draufsicht auf die erfindungsgemäße Anordnung
- Figur 3: schematisch und beispielhaft eine Längsschnittansicht der erfindungsgemäße Anordnung entlang der Schnittlinie A-A

### Ausführung der Erfindung

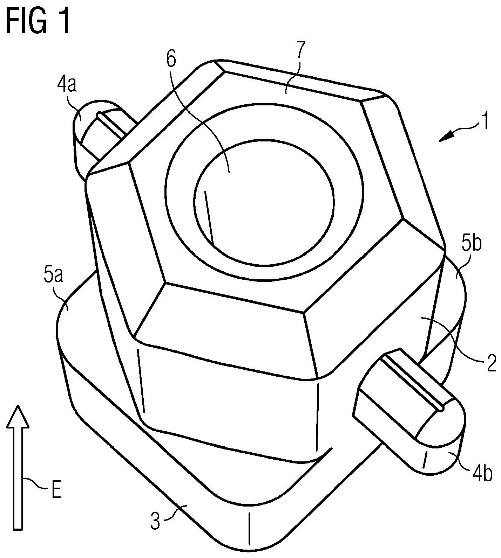

Figur 1 zeigt in schematischer Weise eine perspektivische Ansicht einer beispielhaften Ausführungsform eines Verbindungselements 1 vor einem Einfügen in einen Auslass einer Leiterplatte. Das Verbindungselement 1 ist dabei aus einer Sicht entgegen einer Einfügerichtung E dargestellt, in welcher das Verbindungselement 1 in den Leiterplattenauslass eingefügt wird. Das Verbindungelement 1 ist einteilig aus einem nicht elektrisch leitfähigen bzw. isolierenden Material, wie z.B. Kunststoff, Keramik, etc. hergestellt. Eine Herstellung kann beispielsweise mittels eines Spritzgussverfahrens erfolgen.

Das Verbindungselement 1 weist einen Grundkörper 2 und eine Gegenhalterung 3 auf. Der Grundkörper 2 des Verbindungselements 1 ist in einen entsprechenden Auslass in einer Leiterplatte einfügbar und ist dazu eingerichtet, ein Verdrehen des Verbindungselements 1 nach Einfügen in den Leiterplattenauslass zu verhindern. Dazu weist der Grundkörper beispielsweise einen polygonförmigen Querschnitt (z.B. dreieckig, rechteckig, etc.) auf. In der dargestellten, beispielhaften Ausführungsform ist der Querschnitt des Grundkörpers 2 beispielsweise als Hexagon ausgeführt.

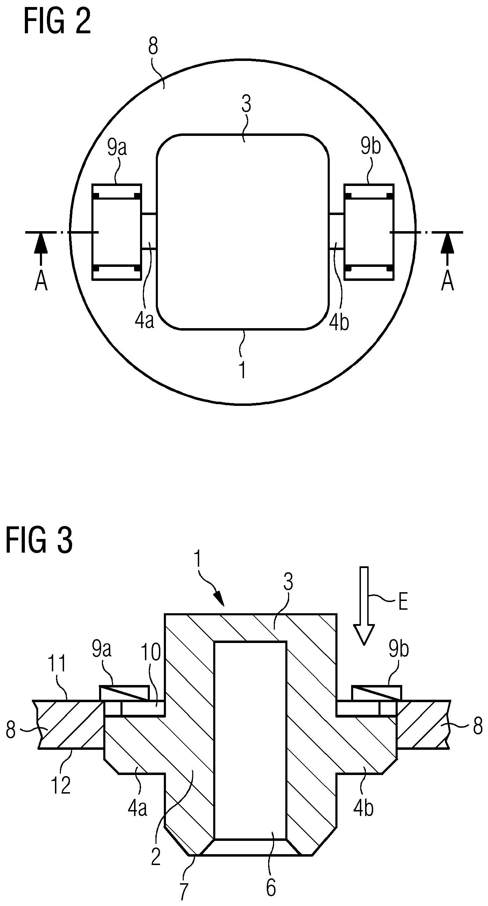

Weiterhin weist der Grundkörper 2 zumindest einen Abschnitt 4a, 4b auf, welcher über einen Querschnitt der Gegenhalterung 3 hinausragt. Bei der in Figur 1 beispielhaft dargestellten Ausführungsform des Verbindungselements sind beispielsweise zwei derartige Abschnitte 4a, 4b an der Grundform vorhanden, wobei diese beispielsweise als Nasen 4a, 4b ausgestaltet sind. Die Nasen 4a, 4b sind z.B. in Umfangrichtung des Grundkörpers 2 auf gegenüberliegenden Seiten des Grundkörpers 2 angeordnet. Die Nasen 4a, 4b dienen der Lagestabilisierung des Verbindungselements 1 in der Anordnung - dies wird anhand der folgenden Figuren 2 und 3 noch näher erläutert. Weiterhin dienen die Nasen 4a, 4b als Verdrehschutz, insbesondere bei einer Endmontage der bestückten Leiterplatte bzw. beim Verbinden der bestückten Leiterplatte mit einem weiteren Geräteteil des elektrischen Geräts. Eine Anzahl der über den Querschnitt der Gegenhalterung 3 hinausragenden Abschnitte 4a, 4b des Grundkörpers 2 bzw. der Nasen 4a, 4b kann je nach Stabilitätsbedarf und zu gewährleistender Verdrehsicherheit allerdings beliebig erweitert oder reduziert werden. Alternativ können die am Grundkörper 2 vorhandenen Abschnitte 4a, 4b auch als Rasthaken ausgestaltet sein, welche beim Einfügen in den Leiterplattenauslass verrasten und das Verbindungselement 1 dadurch stabilisieren.

Die Gegenhalterung 3 des Verbindungselements 1 ist an einem oberen Ende des Grundkörpers 2 angebracht. Dabei ist die Gegenhalterung 3 derart ausgestaltet, dass das Verbindungselement 1 automatisiert - z.B. mittels SMD-Bestückung - mit dem Grundkörper 2 in Einfügerichtung E in den Leiterplattenauslass eingefügt werden kann. So kann beispielsweise eine in Figur 1 nicht sichtbar dargestellte Oberfläche der Gegenhalterung 3, welche auch ein oberes Ende des Verbindungselements 1 bildet, derart ausgestaltet sein, dass das Verbindungselement zum Platzieren im Leiterplattenauslass z.B. von einer Saugpipette eines Bestückautomaten sehr leicht angesaugt, transportiert und platziert werden kann.

Weiterhin weist die Gegenhalterung 3 zumindest einen Abschnitt 5a, 5b auf, welcher über den polygonförmigen Querschnitt des Grundkörpers 2 des Verbindungselements 1 hinausragt. In der dargestellten Ausführungsform weist die Gegenhalterung 3 beispielsweise einen rechteckigen Querschnitt auf sowie z.B. zwei Abschnitte 5a, 5b, welche als Auskragungen über gegenüberliegende Seiten des Grundkörpers 2 hinausragen, während jene Seiten des Grundkörpers 2, an welche die Nasen 4a, 4b angebracht sind bzw. auf welchen die Nasen 4a, 4b über die Gegenhalterung 3 hinausragen, bündig mit entsprechenden Seitenflächen der Gegenhalterung 3 abschließen. Die Auskragungen 5a, 5b der Gegenhalterung 3 verhindern beispielsweise ein Durchfallen des Verbindungselements 1 beim automatisierten Einfügen z.B. mittels SMD-Bestückung in den entsprechenden Leiterplattenauslass. Weiterhin sind die Auskragungen 5a, 5b der Gegenhalterung 3 zu den Abschnitten 4a, 4b bzw. Nasen des Grundkörpers 2 versetzt angeordnet. Dabei überdecken die Auskragungen 5a, 5b die Abschnitte 4a, 4b bzw. Nasen 4a, 4b des Grundkörpers 2 nicht. In der dargestellten Ausführungsform sind beispielsweise die Nasen 4a, 4b des Grundkörpers 2 gegenüber den Auskragungen der Gegenhalterung 3 um 90 Grad versetzt.

Weiterhin ist das Verbindungselement 1 dazu eingerichtet, ein Befestigungsmittel - z.B. Stift, Niete, Zapfen, Schraube, etc. - für die Verbindung der Leiterplatte mit dem weiteren Geräteteil des elektrischen Geräts aufzunehmen. Dazu weist das Verbindungselement 1 eine Bohrung 6 auf, welche beispielsweise als Sackloch oder als Durchgangsloch ausgestaltet ist. Die Bohrung 6 kann beispielsweise ohne Gewinde oder mit Gewinde ausgeführt sein.

Bei der in Figur 1 beispielhaft dargestellten Ausführungsform ist ein in Einfügerichtung E unteres Ende 7 des Grundkörpers 2 weiterhin in Form einer Sechskantmutter ausgestaltet. Dadurch kann beispielsweise für die mechanische Verbindung der Leiterplatte an dem weiteren Geräteteil, wie z.B. einem Gehäuse, des elektrischen Geräts entgegen der Einfügerichtung E eine Senkkopfschraube in die Bohrung 6 eingebracht werden. Die Schraube ragt dann beispielweise nach der Endmontage der bestückten Leiterplatte nicht über das Verbindungselement 1 hinaus.

Weiterhin ist das Verbindungselement 1 nicht nur aus nicht elektrisch leitfähigem bzw. isolierendem Material hergestellt, sondern das Material sollte auch hitzebeständig sein. D.h., das Material des Verbindungselements 1 weist einen Schmelzpunkt auf, der über einem Temperaturbereich liegt, welcher in einem Ofen (z.B. SMD-Ofen) einer Fertigungsanlage zum Auflöten von bestückten Bauelementen auf eine Leiterplatte verwendet wird.

Es besteht auch die Möglichkeit, dass das Verbindungselement 1 aus Materialien mit unterschiedlicher Hitzebeständigkeit hergestellt ist. Dabei kann beispielsweise die Grundform 2 mit ihren Abschnitten 4a, 4b bzw. Nasen 4a, 4b aus einem ersten Material bestehen, dessen Schmelzpunkt über dem Temperaturbereich des Ofens (z.B. SMD-Ofen) der Fertigungsanlage liegt. Die Gegenhaltung 3 des Verbindungselements 1 kann beispielsweise aus einem zweiten Material bestehen, welches eine Glasübergangstemperatur aufweist, die im Temperaturbereich des Ofens der Fertigungsanlage liegt. Die Glasübergangstemperatur ist jene Temperatur, bei deren Überschreiten z.B. festes Glas oder ein festes Polymer in einen gummiartigen bis zähflüssigen Zustand übergeht. Dadurch kann beispielsweise die Gegenhalterung 3 des Verbindungselements 1 beim Durchlaufen des SMD-Ofen mit der Leiterplatte - z.B. für einen besseren Halt - verschmelzen.

Figur 2 zeigt beispielhaft und schematisch eine Draufsicht auf die erfindungsgemäße Anordnung, welche die in Figur 1 dargestellte beispielhafte Ausführungsform des Verbindungselements 1 umfasst. In Figur 2 ist ein Ausschnitt einer Leiterplatte 8 dargestellt, welche mit dem Verbindungselement 1 und elektrischen Bauelementen 9a, 9b z.B. mittels SMD-Bestückung bestückt wurde. Das Verbindungselement 1 ist in einen Auslass in der Leiterplatte 8 eingefügt, wobei in der Draufsicht die Oberseite der Gegenhalterung 3 zu sehen ist.

Die Gegenhalterung 3 ragt dabei aufgrund der über den Grundkörper 2 des Verbindungselements 1 hinausragenden Abschnitte 5a, 5b über einer Oberseite der Leiterplatte 8 hinaus. Vom Grundkörper 2 des Verbindungselements sind nur Ausschnitte der über den Querschnitt der Gegenhalterung 3 hinausragenden Abschnitte 4a, 4b bzw. Nasen 4a, 4b zu sehen, wobei der Grundkörper 2 mit den Abschnitten 4a, 4b bzw. Nasen 4a, 4b unterhalb einer Oberkante des Auslasses in der Leiterplatte 8 gelegen ist. Oberseiten der Abschnitte 4a, 4b bzw. der Nasen 4a, 4b des Grundkörpers 2 sind maximal bündig mit der Oberkannte des Leiterplattenauslasses und überragen diese nicht.

Weiterhin sind bestückbare, elektrische Bauelemente 9a, 9b auf der Leiterplatte 8 derart angebracht, dass das Verbindungselement 1 lagestabil im Leiterplattenauslass gehalten wird. D.h. die Anbringung der elektrischen Bauelemente 9a, 9b hält das Verbindungselement 1 im Auslass und verhindert bis zu einer Endmontage der bestückten Leiterplatte 8 im elektrischen Gerät ein Herausfallen des Verbindungselements 1**.** Die Bauelemente 9a, 9b sind dabei so auf der Leiterplatte angebracht, dass die Abschnitte 4a, 4b bzw. Nasen 4a, 4b des Grundkörpers 2 des Verbindungselements 1 von den Bauelementen 9a, 9b überdeckt werden. Die Anbringung der Bauelemente 9a, 9b auf der Leiterplatte 8 kann beispielsweise lösbar oder unlösbar sein. Üblicherweise werden die Bauelemente 9a, 9b in einem SMD-Ofen aufgelötet und mit der Leiterplatte 8 fix verbunden.

Figur 3 zeigt schematisch und beispielhaft zur deutlicheren Veranschaulichung der Anordnung einen Längsschnitt durch die Anordnung entlang der in Figur 2 dargestellten Schnittlinie A-A**.** In Figur 3 ist wieder die beispielhafte Ausführungsform des Verbindungselements 1 aus Figur 1 dargestellt. Das Verbindungselement 1 ist mit dem Grundkörper 2 in Einfügerichtung E in einen Auslass 10 in der Leiterplatte 8 z.B. mittels SMD-Bestückung eingefügt, wobei die Gegenhalterung 3 über eine Oberseite 11 der Leiterplatte 8 bzw. eine Oberkante des Auslasses 10 hinausragt - aufgrund der in Figur 3 nicht sichtbar dargestellten Abschnitte 5a, 5b der Gegenhalterung bzw. der Auskragungen 5a, 5b. Der Grundkörper 2 des Verbindungselements 1 mit den Abschnitten 4a, 4b bzw. Nasen 4a, 4b liegt unterhalb der Oberseite 11 der Leiterplatte 8 und ragt beispielsweise über eine Unterseite 12 der Leiterplatte 8 hinaus, um eine mechanische Verbindung mit einem weiteren Geräteteil, wie z.B. einem Gehäuse, auf welchem die bestückte Leiterplatte 8 montiert werden soll, herstellen zu können.

Für diese mechanische Verbindung mit einem weiteren Geräteteil weist das Verbindungselement 1 beispielsweise eine Bohrung 6 auf, welche z.B. als Sackloch ausgestaltet ist. In die Bohrung 6 kann zum Befestigen der Leiterplatte 8 am weiteren Geräteteil z.B. ein Befestigungsmittel, wie z.B. ein Stift, Zapfen oder eine Schraube, etc., entgegen der Einfügerichtung E des Verbindungselements 1 eingebracht werden. Das untere Ende 7 des Grundkörpers 2 des Verbindungselements kann beispielsweise derart ausgestaltet sein, dass das Befestigungsmittel (z.B. Schraube) im endmontierten Zustand der Leiterplatte nicht über das Verbindungselement 1 hinausragt. So kann das Ende 7 z.B. die Form einer Mutter mit abgeschrägten Innenkanten aufweisen, in welche z.B. ein Kopf eines Befestigungsmittels (z.B. Schraubkopf, Kopf eines Stifts, etc.) versenkt werden kann.

Um das Verbindungselement 1 lagestabil in der Leiterplatte 8 zu halten, weist die Anordnung zumindest ein elektrisches Bauelement 9a, 9b auf. In der beispielhaften Ausführungsform der Anordnung sind für jeden Abschnitt 4a, 4b bzw. für jede Nase 4a, 4b des Grundkörpers 2 jeweils ein elektrisches Bauelement 9a, 9b vorgesehen. Die Bauelemente 9a, 9b sind dabei auf der Oberfläche 11 der Leiterplatte 8 derart angebracht, dass die Abschnitte 4a, 4b bzw. die Nasen 4a, 4b des Grundkörpers 2 des Verbindungselements 1 von den elektrischen Bauelementen 9a, 9b überdeckt werden. Dazu ist beispielsweise ein erstes Bauelement 9a über einem Abschnitt des Leiterplattenauslasses 10 angebracht bzw. bestückt, in welchem eine erste Nase 4a des Verbindungselements 1 gelegen ist, und ein zweites Bauelement 9b über einem Abschnitt des Leiterplattenauslasses 10 angebracht bzw. bestückt wird, in welchem eine zweite Nase 4b des Grundkörpers 2 des Verbindungselements 1 gelegen ist. Eine derartige Anbringung - beispielsweise mittels Bestückung und Verlötung - hält das Verbindungselement 1 lagestabil in der Leiterplatte 8 und verhindert ein Herausfallen. Als Bauelemente 9a, 9b können beispielsweise beliebige elektrisch leitfähige und bestückbare (z.B. mittels SMD-Bestückung) Bauelemente 9a, 9b, wie z.B. Widerstände, etc., verwendet werden.

Die Anzahl der Abschnitte 4a, 4b bzw. Nasen 4a, 4b am Grundkörper 2 des Verbindungselements 1 kann beispielsweise je nach Stabilitätsbedarf und zu gewährleistender Verdrehsicherheit des Verbindungselements 1 beliebig erweitert oder reduziert werden. Aus dieser Anzahl ergibt sich auch eine Anzahl an Bauelementen 9a, 9b, welche über den am Verbindungselement 1 vorhandenen Abschnitte 4a, 4b bzw. Nasen 4a, 4b des Grundkörpers 2 für einen entsprechende Lagestabilisierung des Verbindungselements 1 bestückt werden müssen.

Bei einer sehr einfachen, beispielhaften und nicht der beanspruchten Erfindung entsprechenden Ausführungsform des Verbindungselements 1 weist dieses am Grundkörper 2 z.B. keine Abschnitte 4a, 4b bzw. Nasen 4a, 4b, etc. auf, welche über die Gegenhalterung 3 hinausragen. In diesem Fall kann beispielsweise die Gegenhalterung 3 des Verbindungselements 1 mit einem geeigneten, elektrischen Bauelement 9a, 9b mittels Bestückung so bedeckt werden, dass das Verbindungselement 1 ausfallsicher ist bzw. in der Leiterplatte 8 gehalten wird.

### Bezugszeichenliste

- 1: Verbindungselement
- 2: Grundkörper
- 3: Gegenhalterung
- 4a, 4b: Abschnitte des Grundkörpers, welche über einen Querschnitt der Gegenhalterung hinausragen bzw. Nasen
- 5a, 5b: Abschnitte der Gegenhalterung, welche einen Querschnitt des Grundkörpers bzw. Auskragung
- 6: Bohrung zum Aufnehmen eines Befestigungsmittels
- 7: untere Ende des Grundkörpers
- 8: Leiterplatte
- 9a, 9b: elektrische Bauelemente
- 10: Auslass in der Leiterplatte
- 11: Oberseite der Leiterplatte
- 12: Unterseite der Leiterplatte

- E: Einfügerichtung
- A: Schnittlinie

## Patentansprüche

1. Anordnung, durch welche eine Leiterplatte (8), welche mit elektrischen Bauelementen (9a, 9b) bestückbar ist, mit einem weiteren Geräteteil, insbesondere einem Gehäuse, eines elektrischen Geräts mechanisch verbindbar ist, wobei die Anordnung zumindest aufweist:
- ein aus nicht elektrisch leitfähigem Material hergestelltes Verbindungselement (1), welches dazu eingerichtet ist, ein Befestigungsmittel für eine Verbindung mit dem weiteren Geräteteil aufzunehmen, und welches zumindest einen Grundkörper (2) und eine Gegenhalterung (3) aufweist, wobei der Grundkörper (2) in einen entsprechenden Auslass (10) in der Leiterplatte (8) einfügbar ist und dazu eingerichtet ist, ein Verdrehen des Verbindungselements (1) nach Einfügen in die Leiterplatte (8) zu verhindern, wobei die Gegenhalterung (3) an einem in Einfügerichtung (E) oberen Ende des Grundkörpers (2) angebracht ist und zumindest einen Abschnitt (5a, 5b) aufweist, welcher über eine Querschnitt des Grundkörpers (2) hinausragt, und wobei weiterhin der Grundkörper (2) mit zumindest einem Abschnitt (4a, 4b) über einen Querschnitt der Gegenhaltung (3) hinausragt, welcher Abschnitt (4a, 5b) gegenüber dem zumindest einen Abschnitt (5a, 5b) der Gegenhalterung (3) versetzt angeordnet ist;
- **gekennzeichnet dadurch, dass** die Anordnung weiterhin zumindest ein elektrisches Bauelement (9a, 9b) aufweist, welches derart auf der Leiterplatte (8) lösbar oder unlösbar angebracht ist, dass das Verbindungselement (1) lagestabil im Auslass (10) in der Leiterplatte (8) gehalten wird;
- dass weiterhin das zumindest eine elektrische Bauelement (9a, 9b) derart auf der Oberseite der Leiterplatte (8) angebracht ist, dass der zumindest eine Abschnitt (4a, 4b) des Grundkörpers (2) des Verbindungselements (1) vom zumindest einen elektrischen Bauelement (9a, 9b) überdeckt wird;
- dass der zumindest eine Abschnitt (5a, 5b) der Gegenhalterung (3) so über den Querschnitt des Grundkörpers (2) und eine Oberkante des Auslasses hinausragt, dass ein Durchfallen des Verbindungselements (1) durch den Auslass der Leiterplatte (8) verhindert wird;
- und dass der Grundkörper (2) des Verbindungselements (1) mit dem Abschnitt (4a, 4b) unterhalb der Oberseite (11) der Leiterplatte (8) liegt.

2. Anordnung nach Anspruch 1, ***dadurch gekennzeichnet, dass*** das Verbindungselement (1) eine Bohrung (6) zum Aufnehmen des Befestigungsmittels für die mechanische Verbindung mit dem weiteren Geräteteil aufweist.

3. Anordnung nach einem der Ansprüche 1 bis 2, ***dadurch gekennzeichnet, dass*** die Bohrung (6) als Sackloch oder als Durchgangsloch ausgestaltet ist.

4. Anordnung nach einem der vorangegangenen Ansprüche, ***dadurch gekennzeichnet, dass*** der Grundkörper (2) des Verbindungselement (1) einen polygonförmigen Querschnitt aufweist.

5. Anordnung nach einem der Ansprüche 1 bis 4, ***dadurch gekennzeichnet, dass*** der zumindest eine Abschnitt (4a, 4b) des Grundkörpers (2) des Verbindungselements (1), welcher über den Querschnitt des Gegenhalterung (3) des Verbindungselements (1) hinausragt, als Nase ausgestaltet ist.

6. Anordnung nach einem der Ansprüche 1 bis 4, ***dadurch gekennzeichnet, dass*** der zumindest eine Abschnitt (4a, 4b) des Grundkörpers (2) des Verbindungselements (1), welcher über den Querschnitt des Gegenhalterung (3) des Verbindungselements (1) hinausragt, als Rasthaken ausgestaltet ist.

7. Anordnung nach einem der vorangegangen Ansprüche, **dadurch *gekennzeichnet, dass*** die Gegenhalterung (3) des Verbindungselements (1) derart ausgestaltet ist, dass das Verbindungselement (1) automatisiert, insbesondere mittels SMD-Bestückung, in den Auslass (10) in der Leiterplatte (8) einfügbar ist.

8. Anordnung nach einem der vorangegangenen Ansprüche, ***dadurch gekennzeichnet, dass*** das Verbindungselement (1) mittels Spritzguss, insbesondere mittels Zweikomponentenspritzguss, herstellbar ist.

## Claims

1. Assembly, by means of which a circuit board (8), which can be equipped with electrical components (9a, 9b), can be mechanically connected to a further device part, in particular a housing, of an electrical device, wherein the assembly has at least:
- a connecting element (1) produced from non-electrically conductive material, which is designed to accommodate a fastening means for a connection to the further device part, and which has at least a base body (2) and a counter support (3), wherein the base body (20) can be inserted into a corresponding outlet (10) in the circuit board (8) and is designed to prevent a rotation of the connecting element (1) after insertion into the circuit board (8), wherein the counter support (3) is attached to an upper end of the base body (2) in the insertion direction (E) and has at least one section (5a, 5b), which projects beyond a cross-section of the base body (2), and wherein the base body (2) also projects beyond a cross-section of the counter support (3) with at least one section (4a, 4b), which section (4a, 5b) is arranged offset with respect to the at least one section (5a, 5b) of the counter support (3);
- **characterised in that** the assembly also has at least one electrical component (9a, 9b), which is attached to the circuit board (8) in a detachable or non-detachable manner so that the connecting element (1) is held in a positionally stable manner in the outlet (10) in the circuit board (8);
- the at least one electrical component (9a, 9b) is also attached to the top side of the printed circuit board (8) so that the at least one section (4a, 4b) of the base body (2) of the connecting element (1) is covered by at least one electrical component (9a, 9b);
- the at least one section (5a, 5b) of the counter support (3) projects beyond the cross-section of the base body (1) and an upper edge of the outlet so that the connecting element (1) is prevented from falling through the outlet of the circuit board (8) ;
- and that the base body (2) of the connecting element (1) lies with the section (4a, 4b) below the top side (11) of the circuit board (8).

2. Assembly according to claim 1, **characterised in that** the connecting element (1) has a borehole (6) for receiving the fastening means for the mechanical connection to the further device part.

3. Assembly according to one of claims 1 to 2, **characterised in that** the borehole (6) is designed as a blind hole or as a through hole.

4. Assembly according to one of the preceding claims, **characterised in that** the base body (2) of the connecting element (1) has a polygon-shaped cross-section.

5. Assembly according to one of claims 1 to 4, **characterised in that** the at least one section (4a, 4b) of the base body (2) of the connecting element (1), which projects beyond the cross-section of the counter support (3) of the connecting element (1), is designed as a lug.

6. Assembly according to one of claims 1 to 4, **characterised in that** the at least one section (4a, 4b) of the base body (2) of the connecting element (1), which projects beyond the cross-section of the counter support (3) of the connecting element (1), is designed as a locking hook.

7. Assembly according to one of the preceding claims, **characterised in that** the counter support (3) of the connecting element is designed so that the connecting element (1) can be automatically inserted into the outlet (10) in the circuit board (8) in particular by means of SMD mounting.

8. Assembly according to one of the preceding claims, **characterised in that** the connecting element (1) can be established by means of injection moulding, in particular by means of two component injection moulding.

## Revendications

1. Agencement avec lequel une carte de circuit imprimé (8) pouvant être équipée de composants électriques (9a, 9b) peut être fixée à une autre partie d'un appareil, en particulier un boîtier, d'un appareil électrique, dans lequel l'agencement comprend au moins :
- un élément de liaison (1) fabriqué avec un matériau non conducteur d'électricité, qui est conçu pour recevoir un moyen de fixation pour une liaison avec l'autre partie de l'appareil et qui présente au moins un corps de base (2) et un contre-support (3), dans lequel le corps de base (2) peut être inséré dans une sortie (10) correspondante dans la carte de circuit imprimé (8) et est conçu pour empêcher une rotation de l'élément de liaison (1) après son insertion dans la carte de circuit imprimé (8), dans lequel le contre-support (3) est fixé à une extrémité supérieure du corps de base (2) dans le sens d'insertion (E) et comporte au moins une section (5a, 5b) qui dépasse d'une section transversale du corps de base (2), et en outre dans lequel le corps de base (2) dépasse avec au moins une section (4a, 4b) une section transversale du contre-support (3), laquelle section (4a, 4b) est disposée de manière décalée par rapport à au moins une section (5a, 5b) du contre-support (3) ;
- **caractérisé en ce que** l'agencement comprend en outre au moins un composant électrique (9a, 9b) qui est fixé de manière amovible ou non amovible sur la carte de circuit imprimé (8) de telle sorte que l'élément de liaison (1) est maintenu dans une position stable à l'intérieur de la sortie (10) de la carte de circuit imprimé (8) ;
- **en ce que** l'au moins un composant électrique (9a, 9b) est monté sur la face supérieure de la carte de circuit imprimé (8) de telle sorte que l'au moins une section (4a, 4b) du corps de base (2) de l'élément de liaison (1) est recouverte par l'au moins un composant électrique (9a, 9b) ;
- **en ce qu'**au moins une section (5a, 5b) du contre-support (3) dépasse la section transversale du corps de base (2) et d'un bord supérieur de la sortie, de manière à empêcher l'élément de liaison (1) de tomber à travers la sortie de la carte de circuit imprimé (8) ;
- et **en ce que** le corps de base (2) de l'élément de liaison (1) avec la section (4a, 4b) se trouve sous la face supérieure (11) de la carte de circuit imprimé (8).

2. Agencement selon la revendication 1, **caractérisé en ce que** l'élément de liaison (1) comporte un alésage (6) destiné à recevoir le moyen de fixation pour la liaison mécanique avec l'autre partie de l'appareil.

3. Agencement selon l'une des revendications 1 à 2, **caractérisé en ce que** l'alésage (6) est conçu comme un trou borgne ou comme un trou traversant.

4. Agencement selon l'une des revendications précédentes, **caractérisé en ce que** le corps de base (2) de l'élément de liaison (1) présente une section transversale polygonale.

5. Agencement selon l'une des revendications 1 à 4, **caractérisé en ce que** l'au moins une section (4a, 4b) du corps de base (2) de l'élément de liaison (1), qui dépasse de la section transversale du contre-support (3) de l'élément de liaison (1), est conçue comme une saillie.

6. Agencement selon l'une des revendications 1 à 4, **caractérisé en ce que** l'au moins une section (4a, 4b) du corps de base (2) de l'élément de liaison (1), qui dépasse de la section transversale du contre-support (3) de l'élément de liaison (1), est conçue comme un crochet d'encliquetage.

7. Agencement selon l'une des revendications précédentes, **caractérisé en ce que** le contre-support (3) de l'élément de liaison (1) est conçu de telle sorte que l'élément de liaison (1) peut être inséré automatiquement, en particulier au moyen d'un montage CMS, dans la sortie (10) de la carte de circuit imprimé (8).

8. Agencement selon l'une des revendications précédentes, **caractérisé en ce que** l'élément de liaison (1) peut être fabriqué par moulage par injection, en particulier par moulage par injection à deux composants.
